(19) Europäisches Patentamt
European Patent Office
Office européen des brevets

(11) **EP 1 626 507 B1**

(12) **EUROPÄISCHE PATENTSCHRIFT**

(45) Veröffentlichungstag und Bekanntmachung des Hinweises auf die Patenterteilung:
**20.10.2010 Patentblatt 2010/42**

(51) Int Cl.:
***H03M 13/41*** *(2006.01)*

(21) Anmeldenummer: **05012476.7**

(22) Anmeldetag: **10.06.2005**

(54) **Decoder und Verfahren zum Durchführen eines Viterbi-Algorithmus**

Decoder and method for performing a Viterbi algorithm

Décodeur et procédé pour la mise en oeuvre d'un algorithme de Viterbi

(84) Benannte Vertragsstaaten:
**DE FR GB IT NL**

(30) Priorität: **09.08.2004 DE 102004038754**

(43) Veröffentlichungstag der Anmeldung:
**15.02.2006 Patentblatt 2006/07**

(73) Patentinhaber: **Trident Microsystems (Far East) Ltd.**
**Grand Cayman (KY)**

(72) Erfinder:
• **Kiefer, Felix**
**79111 Freiburg (DE)**
• **Temerinac, Miodrag**
**79194 Gundelfingen (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
EP-A- 0 543 554     US-A- 5 448 583

• PAASKE E ET AL: "AN AREA-EFFICIENT PATH MEMORY STRUCTURE FOR VLSI IMPLEMENTATION OF HIGH SPEED VITERBI DECODERS" INTEGRATION, THE VLSI JOURNAL, NORTH-HOLLAND PUBLISHING COMPANY. AMSTERDAM, NL, Bd. 12, Nr. 1, 1. November 1991 (1991-11-01), Seiten 79-91, XP000272942 ISSN: 0167-9260

• STEINERT M ET AL: "Power consumption optimization for low latency Viterbi decoder" PROC. 2004 INTERNATIONAL SYMPOSIUM ON CIRCUITS AND SYSTEMS, Bd. 2, 23. Mai 2004 (2004-05-23), Seiten 377-380, XP010720184 Vancouver, Canada ISBN: 0-7803-8251-X

• BONEK P ET AL: "A variable rate constraint length K=5 Viterbi decoder for 12 Mb/s" PROC. CANADIAN CONFERENCE ON ELECTRICAL AND COMPUTER ENGINEERING, 14. September 1993 (1993-09-14), Seiten 582-585, XP010118011 Vancouver, Canada ISBN: 0-7803-1443-3

• CYPHER R ET AL: "GENERALIZED TRACE-BACK TECHNIQUES FOR SURVIVOR MEMORY MANAGEMENT IN THE VITERBI ALGORITHM*" JOURNAL OF VLSI SIGNAL PROCESSING SYSTEMS FOR SIGNAL, IMAGE, AND VIDEO TECHNOLOGY, KLUWER ACADEMIC PUBLISHERS, DORDRECHT, NL, Bd. 5, Nr. 1, Januar 1993 (1993-01), Seiten 85-94, XP000364288 ISSN: 0922-5773

• RANPARA S ET AL: "A low-power Viterbi decoder design for wireless communications applications" PROC. ASIC/SOC CONFERENCE 1999, 15. September 1999 (1999-09-15), Seiten 377-381, XP010360306 Washington, USA ISBN: 0-7803-5632-2

• SBIM B ET AL: "Pipelined VLSI architecture of the viterbi decoder for IMT-2000" PROC. GLOBECOM 1999, Bd. 1A, 5. Dezember 1999 (1999-12-05), Seiten 158-162, XP010373290 Rio de Janeiro, Brazil

**Beschreibung**

Die Erfindung bezieht sich auf einen Decoder zum Durchführen eines Viterbi-Algorithmus mit den oberbegrifflichen Merkmalen des Patentanspruchs 1 bzw. auf ein Verfahren zum Durchführen eines Viterbi-Algorithmus.

Ein Viterbi-Algorithmus ermöglicht in Kommunikationssystemen eine Korrektur von Übertragungsfehlern. Bekannt ist die Anwendung eines Viterbi-Algorithmus auch aus vielen anderen Suchproblemen, beispielsweise im Bereich der Mustererkennung. Nachteilhaft ist bei dem Viterbi-Algorithmus eine sehr komplexe Berechnung, welche sehr große Speicherressourcen erforderlich macht. Dies führt dazu, dass ein Systemtakt eines Decoders zum Durchführen eines Viterbi-Algorithmus entsprechend hoch sein muss. Der Systemtakt, in dem die einzelnen Operationen des Viterbi-Algorithmus durchgeführt werden sollen, muss im Fall des Einsatzes in Kommunikationssystemen mehrfach höher als die Datenrate sein. Diese Anforderung ist insbesondere in Systemen mit sehr hohen Datenraten, z. B. DVB-Systemen (DVB: Digital Video Broadcasting/Digitales Fernsehsignal) kritisch, weil die benötigten Taktfrequenzen den Einsatz einer teuren Technologie erforderlich machen.

Das Prinzip eines Viterbi-Decoders ist beispielsweise aus "G. David Forney, JR., The Viterbi Algorithm, Proc. IEEE, Vol. 61, No. 3, März 1973, pp. 268 - 278" bekannt. Darin verwendete Blöcke zur Berechnung von Distanzen bzw. Gesamtdistanzen (GD) und von Akkumulationen und Vergleichen (AV) sowie eine generische Struktur eines logischen Blocks für einen Viterbi-Decoder werden in Decodern gemäß EP 0 769 853 A1 eingesetzt. Parallelisierungsmöglichkeiten sind bekannt aus "H. Burckhardt and L. C. Barbosa, Contributions to the Application of the Viterbi Algorithm, IEEE Trans. on IT, Vol. 31, No. 5, September 1985, pp. 626 - 634" bekannt.

Alle entsprechenden Viterbi-Decoder bzw. Viterbi-Algorithmen gemäß dem Stand der Technik stellen hohe Anforderungen bezüglichen eines höheren Systemtakts.

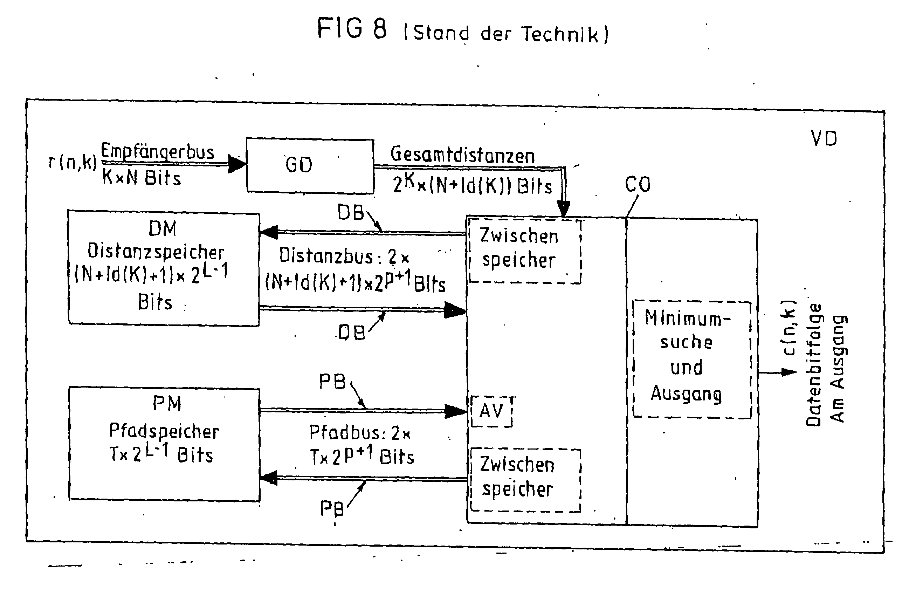

Eine Ausführung eines Viterbi-Decoders VD mit einem Parallelisierungsgrad p gemäß dem Stand der Technik ist in Fig. 8 dargestellt. Über einen Empfängerbus werden $K \times N$ Bits empfangener Daten $r(n,k)$ einem Gesamtdistanz-Block GD zugeführt. In diesem werden Gesamtdistanzen berechnet und entsprechend über einen weiteren Bus $2^K \times$ (N+ld(K)) Bits an eine Berechnungseinrichtung CO mit AV-Blöcken AV zum Akkumulieren und Vergleichen zugeführt. Die Gesamtdistanzen werden in einem Zwischenspeicher LM zwischengespeichert. Über einen Distanzbus DB werden entsprechend $2 \times$ (N+ld(K+1) $\times 2^{p+l}$ Bits an einen Distanzspeicher DM übertragen. Dieser Distanzspeicher DM speichert (N+ld(K)+1) $\times 2^{L-1}$ Bits. Dabei entspricht L der Länge von Generatorpolynomen, von denen ein Satz mit einer Anzahl K bei der Berechnung zu berücksichtigen ist. Die Empfangswerte bzw. Daten $r(n,k)$ sind mit N Bits aufgelöst. Der Parallelisierungsgrad beträgt p. Von dem Distanzspeicher DM wird eine entsprechende Anzahl von $2 \times$ (N+ld(K+1) $\times 2^{p+1}$ Bits zu der Berechnungseinrichtung CO zurückübertragen.

Die Berechnungseinrichtung CO ist außerdem über einen bidirektionalen Pfadbus PB mit einem Pfadspeicher PM verbunden, wobei von dem oder einem weiteren Zwischenspeicher LM der Berechnungseinrichtung CO über diesen Pfadbus PB zu bzw. von dem Pfadspeicher PM in beiden Richtungen $2 \times T \times 2^{p+1}$ Bits zu übertragen sind. Im Pfadspeicher PM werden $T \times 2^{L-1}$ Bits gespeichert. Nach der Durchführung entsprechender Berechnungen, insbesondere Akkumulationen und Vergleiche in der Berechnungseinrichtung CO und den AV-Blöcken AV wird eine Minimumsuche in der Berechnungseinrichtung CO durchgeführt und eine als optimal bestimmte Datenbitfolge $c(n,k)$ wird am Ausgang des Viterbi-Decoders VD bereitgestellt.

Ersichtlich ist bei einem solchen Viterbi-Decoder VD, dass abhängig vom Parallelisierungsgrad (0<p<L-2) ein niedrigerer Systemtakt mit mehreren parallelen Blöcken erreicht werden kann. Im Extremfall, wenn der Systemtakt gleich der Datenrate (p=L-2) ist, müssen alle $2^{L-1}$ AV-Blöcke zum Akkumulieren und Vergleichen parallel realisiert werden. Dabei stellt sich das Buskonzept als der kritischste Begrenzungsfaktor dar. Für die verfügbaren Ausführungen kann gegebenenfalls sogar kein anwendbarer Kompromiss zwischen Systemtakt und den benötigten Busbreiten des Pfadbusses PB und der Distanzbusse DB zusammen gefunden werden.

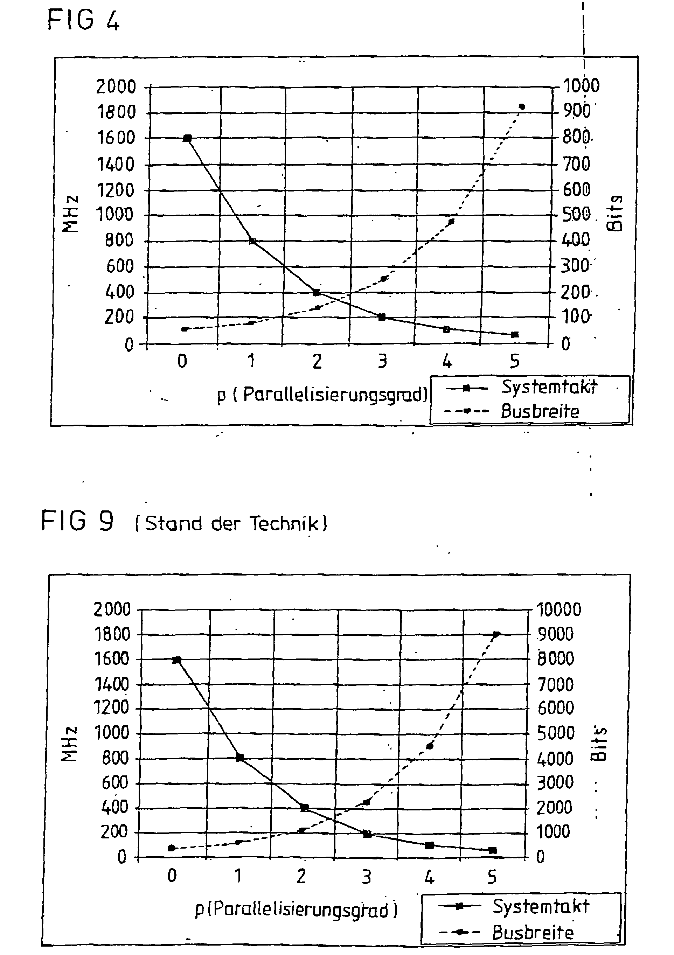

Fig. 9 zeigt das Verhältnis von Systemtakt und Busbreite in Abhängigkeit vom Parallelisierungsgrad p im Fall eines solchen Viterbi-Decoders VD für DVB-Systeme. Die typischen Parameter sind L = 7, K = 2 und T = 64 bei Datenraten bis 50 MBit/s. Im Fall einer nicht vorhandenen Parallelisierung (p = 0) mit einer minimalen Busbreite ist ein Systemtakt von 1600 MHz anzusetzen. Soll der Systemtakt gleich der Datenrate sein, d. h. der Parallelisierungsgrad p = 5, wird eine Bandbreite von knapp 9000 Bits für die Busbreite benötigt. Dies ist in der Praxis mit Blick auf die Umsetzung und die dadurch entstehenden Kosten nicht akzeptierbar. Bei einem akzeptierbaren Systemtakt bis zu 100 MHz (p = 4) ist die benötigte Busbreite mit 4500 Bits für eine kommerziell günstige Lösung immer noch sehr groß.

Aus dem Stand der Technik sind eine Vielzahl von Ansätzen zur Verbesserung von Viterbi-Decodern bekannt, die allerdings nicht gewährleisten können, dass die Taktfrequenz auch bei hohen Bitraten gleich der Datenrate ist.

Konkret lehrt z.B. die US 5 448 583 einen analogen Viterbi-Decoder, der einen Teil der notwendigen Signalverarbeitungsoperationen zur Bereitstellung eines decodierten Signales beispielsweise dadurch ermöglicht, dass die Verzweigungsmetrik in einem Verzweigungsmetrik-Berechnungsschaltkreis und zusätzlich Addition, Vergleich und Selektion in einem ACS-Schaltkreis durchgeführt werden, der analoge Signalprozesse verwendet. Gemäß der Lehre der genannten Druckschrift führt dies zu einem wünschenswerten Rückgang der Vielzahl der Elemente, die für den Viterbi-Decoder notwendig sind und somit zur Möglichkeit, einen kompakten Hochgeschwindigkeitsviterbi-Decoder zu erzeugen.

Der EP 543 554 ist ein Viterbi-Decoder zu entnehmen, der die Decodierung von Datenraten von 30 MegaBit pro Sekunde und mehr zu bewältigen in der Lage ist, wie er beispielsweise für HDTV (High-Definition Television) Sendezwecke verwendet werden muss. Kern des dort offenbarten Viterbi-Decoders ist ein spezieller Pfad-Speicher-Schaltkreis, der aus Pfadspeicherzellen, die in Matrixform angeordnet sind, besteht, wodurch die Möglichkeit entsteht, ein pfaddecodiertes Wort um eine Vielzahl von Zeiteinheiten zu verschieben, wobei die Verschiebung gemäß einem Übergangsdiagramm erfolgt, das auf der Basis der Rechenergebnisse eines Additions-, Vergleichs- und Auswahl (ACS)-Schaltkreises erstellt wird.

Auch in dem Artikel "An area-efficient path memory structure for VLSI implementation of high speed Viterbi-Decoders" bei E. Paaske, S. Pedersen and J. Sparso, Integration, The VLSI Journal, ist eine auf einen speziellen Algorithmus abgestimmte Speicherkonfiguration vorgeschlagen, die auf einen Algorithmus zurückgreift, der die Vorteile des Register exchange algorithmus und des Trace back Algorithmus kombiniert.

Dem Artikel "Power consumption optimization for low latency Viterbi decoder", veröffentlicht von Mario Steinert und Stefano Marsili in den Proceedings des 2004 International Symposium on Circuits and Systems, 23. Mai 2004, Seiten 377 bis 380, wird eine Architektur für einen Viterbi-Decoder vorgestellt, welche hinsichtlich des Aspekts der Leistungsaufnahme bei Beachtung einer gegebenen Latenzbedingung verbessert ist.

Dem Artikel "A variable rate constraint length K=5 Viterbi decoder for 12 mb/s" von Peter Bonek, Andre Ivanov und Samir Kallel, veröffentlicht in den Proceedings der Canadian Conference on electrical and computer Engineering, 14. September 1993, Seiten 582-585, ist ein Viterbi-Decoderchip zu entnehmen, der eine variable Durchsatzrate ermöglicht.

In dem Artikel "Generalized trace-back techniques for survivor memory management in the viterbi algorithm" von Robert Cypher und C. Bernard Shung, veröffentlicht im Journal of VLSI signal processing systems for signal, image and video technology, Band 5 Nr. 1, Januar 1993, Seiten 85-94, wird eine Verallgemeinerung der bekannten Trace back Algorithmen diskutiert und die Auswirkung dieser Verallgemeinerung auf die benötigte Hardware diskutiert.

Der Artikel "A low-power Viterbi decoder design for wirelesscommunication applications" von Samirkumar Ranpara und Dong Sam Ha, veröffentlicht in den Proceedings der ASIC/SOC Conference 1999, 15. September 1999, Seiten 377-381, beschreibt drei weitere Implementationen von Viterbi-Algorithmen, die speziell für drahtlose Kommunikationsanwendungen geeignet sind und sich dadurch auszeichnen, dass die Leistungsaufnahme besonders gering ist.

Der zusammenfassende Überblick über diesen Stand der Technik zeigt deutlich, dass zwar eine Reihe von Verbesserungsansätzen hinsichtlich des bestehenden Designs von Viterbi-Decodern bekannt ist, die insbesondere auf die Ausführung des Pfadspeichers gerichtet sind und diesen entweder hinsichtlich des realisierbaren Durchsatzes oder hinsichtlich des Aufwands und der Komplexität des Speichers zu vereinfachen oder die Leistungsaufnahme zu minimieren.

Ein Hinweis darauf, durch welche Maßnahmen eine Annäherung der Taktfrequenz auch bei hohen Bitraten auf die Datenrate hin möglich gemacht werden kann, findet sich in diesen Druckschriften nicht.

Die Aufgabe der Erfindung besteht darin, einen Viterbi-Decoder bzw. eine Architektur für einen Decoder bzw. ein Verfahren zum Durchführen eines Viterbi-Algorithmus vorzuschlagen, welche den Einsatz einer günstigen Technologie zur Berechnung ermöglichen, wobei insbesondere die Taktfrequenz auch bei hohen Bitraten gleich der Datenrate sein soll.

Diese Aufgabe wird durch einen Decoder zum Durchführen eines Viterbi-Algorithmus mit den Merkmalen des Patentanspruchs 1 bzw. durch ein Verfahren zum Durchführen eines Viterbi-Algorithmus mit den Merkmalen des Patentanspruchs 12 gelöst.

Vorteilhaft ist demgemäss ein Decoder zum Durchführen eines Viterbi-Algorithmus, d.h. insbesondere ein Viterbi-Decoder mit einem Eingang zum Eingeben von Empfangsdatenwerten, einer Berechnungseinrichtung zum Berechnen benötigter Distanzen für die Empfangsdatenwerte und zum Akkumulieren und Vergleichen der Distanzen nach dem Viterbi-Algorithmus und zum Entscheiden von Datenwerten, einem Pfadspeicher zum Speichern entschiedener Datenwerte bzw. Bits, einem Bus zwischen der Berechnungseinrichtung und dem Pfadspeicher und einem Ausgang zum Ausgeben von zumindest einem Ausgangswert, wobei die Berechnungseinrichtung ausgelegt ist, Kontrollsignale abhängig von den Entscheidungen zu Pfaden zugeordnet zu generieren, der Bus ausgebildet ist, die Kontrollsignale zu dem Pfadspeicher zu führen, die Berechnungseinrichtung und/oder der Pfadspeicher ausgelegt sind, mit den zu Pfaden zugeordneten Kontrollsignale im Pfadspeicher entsprechend Bedingungen des Viterbi-Algorithmus Datenfolgen zu verschieben und der Pfadspeicher zum Ausgeben von zumindest dem einen Ausgangswert ausgelegt ist.

Verfahrensgemäß vorteilhaft ist demgemäss ein Verfahren zum Durchführen eines Viterbi-Algorithmus, insbesondere mit einem Decoder nach einem vorstehenden Anspruch, bei dem in einen Eingang Empfangsdatenwerte eingegeben werden, benötigte Distanzen für die Empfangsdatenwerte und zum Akkumulieren und Vergleichen der Distanzen nach dem Viterbi-Algorithmus und zum Entscheiden von Datenwerten in einer Berechnungseinrichtung berechnet werden, in einem Pfadspeicher entschiedene Datenwerte gespeichert werden, über einen Bus zwischen der Berechnungseinrichtung und dem Pfadspeicher Datenwerte übertragen werden und über einen Ausgang zumindest ein Ausgangswert ausgegeben wird, wobei Kontrollsignale abhängig von den Entscheidungen zu Pfaden zugeordnet generiert werden, die Kontrollsignale über den Bus zu dem Pfadspeicher geführt werden, die zu Pfaden zugeordneten Kontrollsignale im Pfadspeicher entsprechend Bedingungen des Viterbi-Algorithmus Datenfolgen verschieben und der Ausgangswert aus dem Pfadspeicher ausgegeben wird.

Vorteilhaft ist insbesondere ein Decoder bzw. Verfahren, bei dem die Berechnungseinrichtung ausgelegt ist, die benötigten Distanzen, insbesondere alle benötigten Distanzen für jeden Satz von den Empfangswerten in einem Block auszuwerten und die Distanzen zugeordnet nach dem Viterbi-Algorithmus zu akkumulieren und zu vergleichen, wobei die insbesondere kleinsten ausgewählt und in einem Distanzspeicher abgelegt werden.

Vorteilhaft ist insbesondere ein Decoder bzw. Verfahren, bei dem die Berechnungseinrichtung und/oder der Pfadspeicher ausgelegt sind, die Datenfolgen in einem zweiten Teil des Pfadspeichers durch einfache Schieberegister zu verzögern zum Ausgleichen einer benötigten Zeit für eine Minimumsuche unter den gewählten, akkumulierten Distanzen.

Vorteilhafte Ausgestaltungen sind Gegenstand von abhängigen Ansprüchen. Den Vorrichtungsmerkmalen sind dabei entsprechende Verfahrensmerkmale zuordbar bzw. umgekehrt.

Vorteilhaft ist insbesondere ein Decoder bzw. Verfahren, bei dem die Berechnungseinrichtung und/oder der Pfadspeicher ausgelegt sind, den Ausgangswert aus dem Pfadspeicher, insbesondere aus einem Schieberegister im Pfadspeicher auszugeben, der dem durch Minimumsuche ausgesuchten Pfad mit der insbesondere minimalen Distanz entspricht.

Vorteilhaft ist insbesondere ein Decoder bzw. Verfahren, bei dem die Berechnungseinrichtung ausgelegt ist, eine gefundene minimale Distanz von allen akkumulierten Distanzen im nächsten Decoderzyklus abzuziehen.

Vorteilhaft ist insbesondere ein Decoder bzw. Verfahren, bei dem der Pfadspeicher zeilenweise aufgebaut ist zum Aufnehmen von zeilenweisen Pfaden aus den Datenfolgen, die beim Entscheiden zu einem Zustand geführt haben und welche in jedem Decoderzyklus neu verschoben werden sollen, insbesondere zum Aufnehmen von Pfaden $m(p,t)$ mit $p=0,1...,P-1$ mit P als Anzahl der Pfade und mit $t=0,1,...,T-1+D$ mit T als Decodertiefe und D als Verzögerung.

Vorteilhaft ist insbesondere ein Decoder bzw. Verfahren, bei dem der Pfadspeicher zwei Teile hat und ausgebildet ist zum Durchführen der Verschiebung nach dem Viterbi-Algorithmus im ersten Teil mit einer vorgegebenen Länge T und einer insbesondere einfachen Verzögerung mittels Schieberegister mit einer weiteren Länge D im zweiten Teil.

Vorteilhaft ist insbesondere ein Decoder bzw. Verfahren, bei dem die Berechnungseinrichtung und/oder der Pfadspeicher ausgelegt sind, den Anfangswert in jedem Pfad ($\{m(p,0)$ für $p=0,1,...,P-1\}$) nach einem festen Muster, der nur von einer Pfadnummer abhängig ist, in jedem Decoderzyklus einzuschreiben.

Vorteilhaft ist insbesondere ein Decoder bzw. Verfahren, bei dem die Berechnungseinrichtung und/oder der Pfadspeicher ausgelegt sind, mittels der Kontrollsignale am Eingang des Pfadspeichers die Datenverschiebung hinsichtlich der Pfade $m(p,t)$ im ersten Teil des Pfadspeichers zu steuern, insbesondere gemäß

$m(p,t)=m(2p+s(p),t-1)$ mit $p=0,1,...,P/2-1$ und $m(P/2+p,t)=m(2p+s(P/2+p),t-1)$ mit $t=1,2,...,T-1$,

für $s(p) \in (0,1,...,S-1)$ für $p=0,1,...,P-1$, wobei S die Anzahl der möglichen Datenwerte darstellt.

Vorteilhaft ist insbesondere ein Decoder bzw. Verfahren, bei dem die Berechnungseinrichtung und/oder der Pfadspeicher ausgelegt sind, eine einfache Verschiebung in einem zweitem Teil des Pfadspeichers durchzuführen, insbesondere gemäß

$m(p,t)=m(p,t-1)$ mit $p=0,1,...,P-1$, $t=T,...,T+D-1$ und/oder den ausgewählten Pfad (q) mit der minimalen Distanz als den Ausgangswert zu bestimmen, insbesondere gemäß Ausgang = $m(q,T+D-1)$.

Vorteilhaft ist insbesondere ein Decoder bzw. Verfahren mit einem Decoder aus drei Blöcken aus der Berechnungseinrichtung für das Auswerten, das Akkumulieren und das Vergleichen der Distanzen mit Generierung der Kontrollsignale sowie für die Minimumsuche und ein Zwischenspeichern für einen Zeitausgleich, einem Distanzspeicher, und dem Pfadspeicher, wobei ein bidirektionaler Bus zwischen dem Distanzspeicher und der Berechnungseinrichtung angeordnet ist zum Ablesen der akkumulierten Distanz aus dem vorletzten Decoderzyklus und zum Abspeichern von neu berechneten, akkumulierten Distanzen, und ein unidirektionaler Bus zwischen der Berechnungseinrichtung und dem Pfadspeicher angeordnet ist zum Übertragen der Kontrollsignale für die Verschiebung im Speicher und zum Übertragen einer Adresse des Pfades mit der minimalen, akkumulierten Distanz.

Vorteilhaft ist insbesondere ein Decoder bzw. Verfahren mit einem Decoder, dessen Systemtakt gleich dem Decoderzyklus bzw. der Datenrate ist, wobei die Anzahl der Blöcke für Akkumulation und Vergleich der Bechnungseinrichtung gleich der Anzahl der Zustände, insbesondere Pfade ist, die Busbreite des Busses zum Distanzspeicher für ein gleichzeitiges Ablesen und Abspeichern der Distanzen für alle Pfade dimensioniert ist, und der Bus zum Pfadspeicher alle Kontrollsignale gleichzeitig durchleitet.

Vorteilhaft ist insbesondere ein Decoder bzw. Verfahren mit einem Decoder, dessen Systemfrequenz als einen Vielfaches X einer Datenrate oder eines Decoderzyklus ist, wobei die Anzahl der Blöcke für Akkumulation und Vergleich in der Berechnungseinrichtung P/X beträgt, wobei P die Anzahl der Pfade oder Zustände darstellt, der Bus zum Distanzspeicher zum Ablesen und Abspeichern von P/X Distanzen ausgelegt ist, und der Bus zum Pfadspeicher zum insbesondere gleichzeitigen Durchleiten von P/X Kontrollsignalen ausgelegt ist.

Vorteilhaft ist insbesondere ein Decoder bzw. Verfahren mit einem Decoder, der ausgelegt ist zum Verarbeiten der Daten als binärer Daten zum Codieren (S=2) und der Datenwerte, insbesondere Bitfolge, welche mit einem Faltungscodierer einer Länge (L Bit) und einer Coderate (1/K) codiert sind, wobei der Empfangsbereich mit N Bits auf einen Bereich der Ganzzahlen von 0 bis 2N-2 aufgelöst ist, wobei die Anzahl der möglichen Zustände bzw. Pfade 2L-1 beträgt, das Verhältnis zwischen der Systemfrequenz und der Datenrate eine Zweierpotenz ist (X = 2x, x=0,1,...,L-2), die Busbreite zum Distanzspeicher zum gleichzeitigen Auslesen und Abspeichern insgesamt 2(N+1d(K)+2)2x+1 Bits beträgt und die Busbreite zum Pfadspeicher 2x+1 Bits für Kontrollsignale und L-1 Bits für die Adresse des Pfades mit der minimalen, akkumulierten Distanz beträgt.

Diese Lösung ermöglicht die Fertigung auch kommerziell günstiger IC-Lösungen (IC: Integrated Circuit / Integrierte Schaltung). Die vorgeschlagene Architektur beinhaltet die für den Viterbi-Algorithmus angepassten Berechnungseinrichtungen und eine effiziente Lösung für eine Speicherstruktur, die ihre Inhalte nach dem Viterbi-Algorithmus in insbesondere einem einzigen Systemtakt austauschen kann.

Ein Ausführungsbeispiel wird nachfolgend anhand der Zeichnung näher erläutert. Es zeigen:

Fig. 1 eine bevorzugte Speicherstruktur für einen Viterbi-Decoder;

Fig. 2 schematisch einen vereinfachten AV-Block zum Akkumulieren und Vergleichen von Daten in einem Viterbi-Decoder;

Fig. 3 schematisch die Anordnung von einzelnen Komponenten in einem Viterbi-Decoder mit einer Speicherstruktur gemäß Fig. 1;

Fig. 4 das Verhältnis von Systemtakt und Busbreite in Abhängigkeit vom Parallelisierungsgrad für einen solchen Viterbi-Decoder;

Fig. 5 schematisch einen Block zum Berechnen von Distanzen gemäß dem Stand der Technik;

Fig. 6 schematisch einen Block zum Akkumulieren und Vergleichen der Distanzen gemäß dem Stand der Technik;

Fig. 7 eine generische Struktur eines Viterbi-Decoders gemäß dem Stand der Technik;

Fig. 8 schematisch Komponenten eines Viterbi-Decoders bei einem Parallelisierungsgrad gemäß dem Stand der Technik;

Fig. 9 schematisch ein Diagramm des Verhältnisses von Systemtakt und Busbreite in Abhängigkeit vom Parallelisierungsgrad eines Viterbi-Decoders gemäß Fig. 8;

Fig. 10 schematisch das Prinzip einer Faltungskodierung; und

Fig. 11 ein Zustandsdiagramm eines Faltungscodierers für eine solche Faltungscodierung.

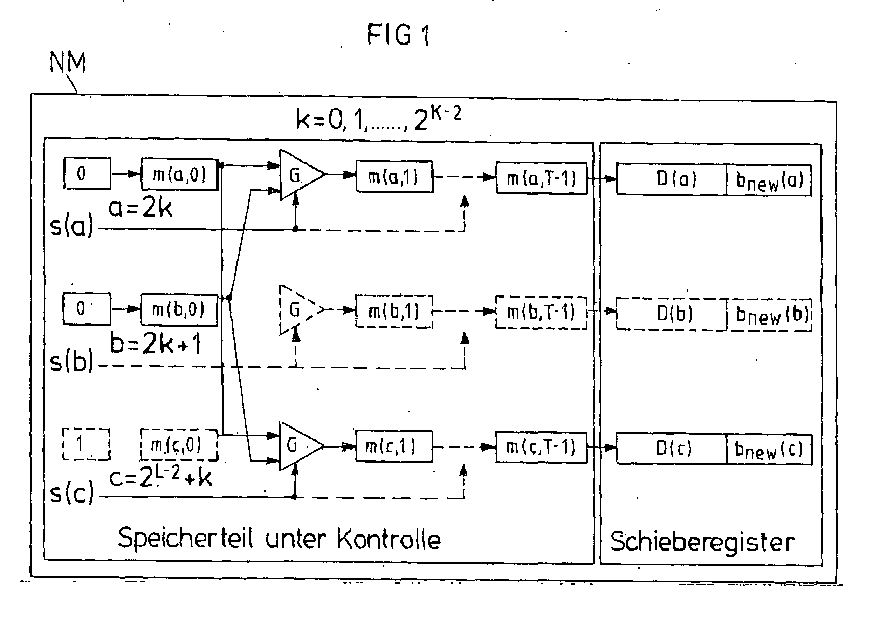

Fig. 1 skizziert eine zweiteilige Speicherstruktur eines Speichers NM zum Einsatz in einem Viterbi-Decoder VD zum Einsatz in Verbindung mit dem Viterbi-Algorithmus bei sehr hohen Datenraten, wobei mit einer einfachen Technologie durch eine nach dem Viterbi-Algorithmus angepasste Struktur des Pfadspeichers als dem Speicher NM ein einfacher Aufbau ermöglicht wird. Dabei wird zugleich die Abhängigkeit zwischen Systemtakt und Busbreite bei jedem Parallelisierungsgrad abgelöst.

In für sich bekannter Art und Weise wird in dem Viterbi-Decoder VD ein Viterbi-Algorithmus durchgeführt. Der Viterbi-Decoder VD befindet sich in einem Kommunikationssystem in einer empfängerseitigen Einrichtung und ist Bestandteil einer in der Regel umfangreichen Signalverarbeitung, welche Demodulation, Entzerrung usw. umfasst.

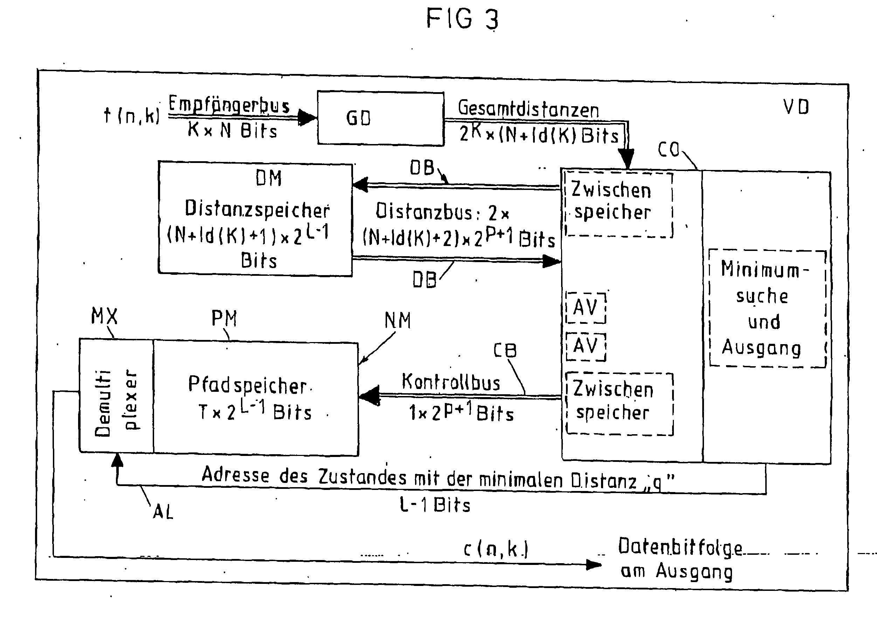

Ein bevorzugter Viterbi-Decoder VD mit einer neuen Speicherstruktur gemäß Fig. 1 ist in Fig. 3 skizziert. Im Vergleich zu dem Viterbi-Decoder aus Fig. 8 gemäß dem Stand der Technik unterscheidet sich der bevorzugte Viterbi-Decoder VD insbesondere dadurch, wie die Berechnungseinrichtung CO, welche AV-Blöcke zum Akkumulieren und Vergleichen der Distanzen umfasst, mit der anhand Fig. 1 beschriebenen Speichereinrichtung NM verbunden ist. Diese Verbindung wird durch einen unidirektionalen Kontrollbus bzw. Steuerbus CB zum Übertragen von insbesondere $1 \times 2^{p+1}$ Bits von der Berechnungseinrichtung CO zur Speichereinrichtung NM aufgebaut.

Der Speicher bzw. die Speichereinrichtung NM setzt.sich zusammen aus dem eigentlichen Pfadspeicher PM mit einem Speicherumfang von $T \times 2^{L-1}$ Bits und einem nachgeschalteten Demultiplexer MX, welcher auch integraler Bestandteil sein kann. Die Berechnungseinrichtung CO umfasst einen Ausgang, aus welchem die Adresse des Zustands mit der bestimmten minimalen Distanz q an den Demultiplexer MX der Speichereinrichtung NM über eine entsprechende Adressleitung ausgegeben wird. Diese Adresse umfasst L - 1 Bits. Vom Demultiplexer bzw. der kombinierten Speichereinrichtung NM wird die entsprechende Datenbitfolge c(n,k) zum Ausgang des Viterbi-Decoders VD geführt.

Letztendlich wird zu jedem codierten Bit c(n,k) der auszugebenden Daten ein Empfangswert r(n,k) zugeordnet. Der Viterbi-Algorithmus soll aus den Empfangswerten r(n,k) eine von einer sendenden Einrichtung gesendete Datenbitfolge {b(n)} mit möglichst wenig Fehlern rekonstruieren. Für den Einsatz des Viterbi-Algorithmus gelten die folgenden Voraussetzungen.

Der Empfangswertebereich ist zwischen zwei nominalen Werten aufgespannt, die den zwei möglichen Werten {W0 und W1} eines codierten Bits (0 oder 1) entsprechen. Im Extremfall, der als "Hard-Decision" bezeichnet wird, beinhaltet der Empfangswertebereich nur die zwei nominalen Werte. Die Effizienz des Decoders verbessert sich bei einer höheren Auflösung des Empfangswertbereiches, was als "Soft-Decision" bezeichnet wird.

Gemäß einem weiteren Aspekt, welche als Voraussetzung anzunehmen ist, ist eine Distanzmetrik durch die Distanzen zwischen Empfangswerten und nominalen Werten definiert durch

$$d_0(r) = \text{Distanz}\{r, W_0\} \quad \text{und} \quad d_1(r) = \text{Distanz}\{r, W_1\}, \qquad (1)$$

wobei $d_0$ bzw. $d_1$ Abweichungswerte bzw. Distanzen beschreiben und angenommen wird, dass eine kleinere Distanz von einem nominalen Wert W eine höhere Wahrscheinlichkeit zu diesem Wert andeutet. Die maximale Distanz $d_0(W_1)$ =$d_1(W_0)$ = $d_{max}$ definiert einem symmetrischen Empfangswertebereich. Auch die Metrik wird vorzugsweise immer so definiert, dass die Summe zweier Distanzen für jeden Empfangswert r(n,k) konstant bleibt, so dass gilt: $d_0(r)+d_1(r)=d_{max}$.

Eine dritte Voraussetzung wird mit Blick auf einen Empfangswertebereich angenommen. Der Empfangswertebereich und die angewendete Metrik sollen die Existenz eines neutralen Wertes $W_n$ garantieren mit $d_0(W_n)=d_1(W_n)$ =$d_{max}/2$. Dieser neutrale Wert wird benötigt, um fehlende Empfangswerte r(n,k) zu ersetzen, welche durch Puncturing ausgelassenen codierten Bits c(n,k) entsprechen.

Eine vierte Voraussetzung betrifft üblicherweise eine Struktur für die Anwendung des Viterbi-Algorithmus. Diese Struktur, beinhaltet für jeden von den $2^{L-1}$ möglichen Zuständen einen Distanzakkumulator {$A_q(n)$, q=0,...,$2^{L-1}$} und einen Pfadspeicher PM mit {$M_q(n)$={$m_q(n,0)$, ... ,$m_q(n,T-1)$}; q=0,...,$2^{L-1}$-1} der Länge T Bits, in dem alle entschiedenen Bits b bis zu jenem Moment n abgespeichert sind, welche zu dem Zustand geführt haben. Der Parameter T definiert eine Decodierungstiefe, die direkt die Effizienz des Viterbi-Decoders bestimmt.

Der Viterbi-Algorithmus beinhaltet mehrere Schritte für jeden neuen Eingang von K Empfangswerten {r(n,0),..., r(n,K-1)}.

Bei einem ersten Schritt wird eine Gesamtdistanz berechnet. Da ein K-Bitsatz einem Bit aus der Datenbitfolge entspricht, wird eine Gesamtdistanz für den ganzen Bitsatz verwendet:

$$d_{c(0),c(1),...,c(K-1)}\{r(n,0),r(n,1),...,r(n,K-1)\} = \sum_{k=0}^{K-1} d_{c(k)}(r(n,k)).$$

$$(2)$$

Mit K Bits {c(0),c(1),...,c(K-1)} sind $2^K$ verschiedene Gesamtdistanzen für einen Satz von K Empfangswerten zu berechnen.

Zweitens werden gemäß einem zweiten Schritt für jeden Zustand zwei konkurrierenden Werte für den Distanzakkumulator berechnet und verglichen, was auch als AC-Operation (AC: Accumulate and Compare/ Akkumuliere und Vergleiche) bezeichnet wird:

$$A_{new/0} = A_{old/b=0} + d_{c/b=0}$$
$$A_{new/1} = A_{old/b=1} + d_{c/b=1} \qquad s = \begin{cases} 0 & A_{new/0} < A_{new/1} \\ 1 & A_{new/0} \geq A_{new/1} \end{cases}, \qquad (3)$$

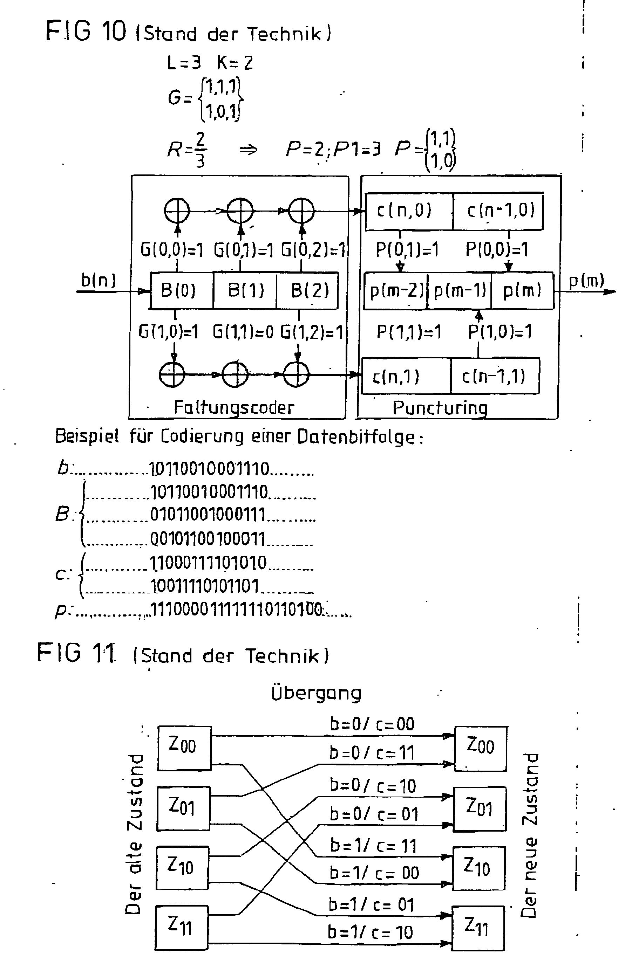

wobei nach einem üblichen Zustandsdiagramm, welches in Fig. 11 skizziert ist, die Werte $A_{old/b}$ aus den Distanzakkumulatoren von zwei möglichen vorangehenden Zuständen stammen und die Werte $d_{C/b}$ als Gesamtdistanzen den codierten K Bits entsprechen.

Bei einem dritten Schritt werden gemäß dem Vergleichergebnis s die folgenden Werte zugeordnet und verschoben, und zwar der Distanzakkumulator $A_{new} = A_{new/s}$, der Pfadspeicher $M_{new}$: $m_{new}(n, 0)$ =b; $m_{new}(n, t)=m_{old/s}$ (n,t-1) mit t=1, ... , T und der Bitkandidat für den Ausgang $b_{new} = m_{old/s}$ (n, T-1) (4), wobei der Bitkandidat b nach dem Zustandsdiagram einem festvorgegebenen Muster folgt, bei dem die erste Hälfte der Zustände eine "0" und der Rest der Zustände eine "1" zugewiesen bekommt.

Gemäß einem vierten Schritt bestimmt der Zustand mit dem minimalen Distanzakkumulator q das neuentschiedene Bit b am Ausgang gemäß

$$A_{min} = A_q(n) = \min_{x=0,...,2^{L-1}-1}\left\{A_x(n)\right\} \Rightarrow b(n) = b_{new/q} \, . \qquad (5)$$

Idealerweise sollte es ein Bit aus der gesendeten Datenbitfolge b(n-T) sein. Die Verzögerung von T wird durch den Decodierungsprozess verursacht.

Gemäß einem fünften Schritt bleiben damit die Werte in den Distanzakkumulatoren begrenzt, wozu das Minimum Aq(n) von allen neugewonnenen Werten in den Distanzakkumulatoren abgezogen wird gemäß $A_{new}$ (n) = $A_{new}$ (n) - $A_q$ (n) .

In einem sechsten Schritt werden diese Werte im nächsten Verlauf als alte Werte eingesetzt bzw. als Werte eingesetzt, welche im nächsten Zyklus zu verwenden sind, so dass gilt:

$$A_{old}(n+1) = A_{new}(n) \quad und \quad M_{old}(n+1) = M_{new}(n) \, . \qquad (8)$$

Als Illustration wird für einen beispielhaften Faltungscode ein am häufigsten angewendetes Verfahren dargestellt. Wenn die Empfangswerte mit N Bits aufgelöst sind, wird der Empfangsbereich Werte $\{0, 1....., 2^N-2\}$ beinhalten, wobei $W_0=0$, $W_1=2^N-2$ und $W_n=2^{N-1}-1$ betragen. Dazu ist eine einfache Metrik angepasst:

$$d_0(r) = r \quad und \quad d_1(r) = 2^N - 2 - r \quad bei \quad r \in \{0,...,2^N-2\}$$
$$\Rightarrow d_{max} = 2^N-2 \quad und \quad 0 \le d_0(r), \, d_1(r) \le 2^N-2 \, . \qquad (9)$$

Der Wertebereich der Gesamtdistanzen, d. h. nach Gleichung (2) insgesamt $2^K$ Werte, ist dann auf ld(K)+N begrenzt und der Wertebereich der Distanzakkumulatoren ist um 1 Bit größer.

Der Viterbi-Decoder VD sowohl der bevorzugten Ausführungsform (Fig. 3) als auch der für sich bekannten Ausführungsform (Fig. 8) umfasst eine Vielzahl von Einzelkomponenten, welche gleich sind, wie beispielsweise ein Block GD zum Berechnen der Distanzen. Einer oder mehrere weitere Blöcke AV dienen zum Bestimmen einer Akkumulation und zum Vergleichen der Distanzen.

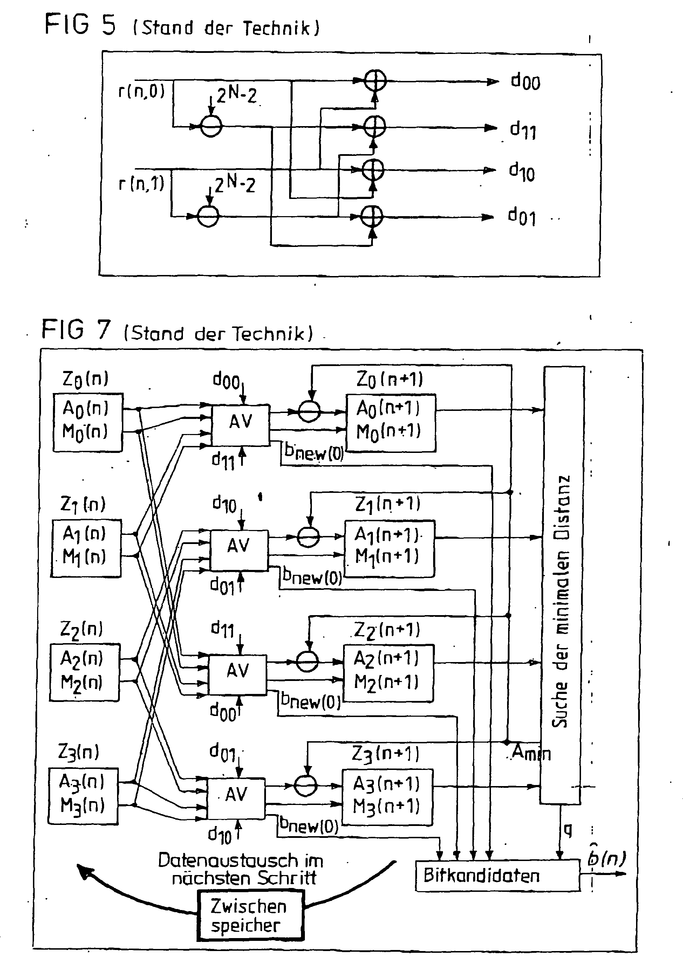

Die Distanzen bzw. Gesamtdistanzen werden insbesondere gemäß den Gleichungen 2 und 7 bestimmt, wozu der Block GD zum Berechnen der Distanzen verwendet wird. Der Block GD zum Berechnen der Distanzen gemäß Fig. 5 umfasst zwei Eingängen zum Eingeben der empfangenen Datenwerte r(n,0) bzw. r(n,1), wobei diese gegebenenfalls einer Vorverarbeitung unterzogen wurden. Jeder dieser Datenwerte r(n,0), r(n,1) wird einem Addierer, d. h. einem ersten bzw. einem dritten Addierer zugeführt. Diesem Addierer wird am anderen Additionseingang der andere dieser beiden Datenwerte r(n,1) bzw. r(n,0) zugeführt. Ausgegeben werden Signale bzw. Datenwerte $d_{00}$ bzw. $d_{10}$. Die empfangenen Datenwerte r(n,0), r(n,1) werden außerdem jeweils einem zugeordneten Subtraktionsglied zugeführt, welches zum Subtrahieren von $2^N-2$ dient. Die Subtraktionsergebnisse werden jeweils einem weiteren, d. h. in der Zeichnung einem zweiten bzw. vierten Addierer zugeführt. Diesen Addierern werden auch die Ergebnisse der Subtraktion des anderen Wertes r(n,1) zugeführt. Die beiden Additionsergebnisse werden als weitere Daten $d_{11}$ bzw. $d_{01}$ ausgegeben.

Die Schritte 2 und 3 des Viterbi-Algorithmus stellen die eigentliche Basisoperation für den Viterbi-Decoder VD dar und werden als AC-Operation (AC: Accumulate + Compare) bezeichnet. Durchgeführt werden diese Schritte in einem oder gemäß der vorliegenden Ausführungsform mehreren parallelen AV-Blöcken AV zur Akkumulation und zum Vergleich der Distanzen.

In Fig. 7 ist eine generische Struktur des für sich bekannten Viterbi-Decoders zum Umsetzen der Gleichungen (5) und (6) dargestellt. Sie zeigt eine Symmetrie, welche die verschiedenen Arten der Parallelisierung ermöglicht. Für jede Anzahl der Zustände kann ein kleinster Verarbeitungsschritt identifiziert werden, in dem 2 Zustände in einem Schritt bearbeitet werden sollen. Allerdings verbieten die unterschiedlichen Reihenfolgen der Eingangs- und Ausgangszustände eine Überschreibung der alten Werte, sobald die Neuen berechnet werden.

Eine "In-place" Berechnung ist demzufolge nicht möglich, so dass ein Zwischenspeicher gemäß der Ausführungsform des Standes der Technik an dieser Stelle unvermeidbar ist. Der Zwischenspeicher soll die neuberechneten Werte $A_{new}$, $M_{new}$ bis zum richtigen Moment für eine Überschreibung aufbewahren. Der Ausführung nach liegt die Größe dieses Zwischenspeichers für alle Zustände zwischen Werten von 1/4 und 1.

Bei einem Parallelisierungsgrad p benötigt die Struktur $2 \times 2^p$ AV-Blöcke in einer parallelen Realisierung und die ganze Prozedur mit 6 Schritten muss $2^{L-3-p}$ mal für jedes Ausgangsbit durchgeführt werden. Es ergibt sich genau das Verhältnis zwischen Systemtakt und Datenrate. Für L=7 ergeben sich zum Beispiel zwei Extreme. Mit 64 AV-Blöcken p=5 ist der Systemtakt gleich der Datenrate und mit nur 2 AV-Blöcken p=0 muss der Systemtakt 32 mal höher als die Datenrate sein.

Die bekannte generische Struktur des Viterbi-Decoders VD wird gemäß dem vorliegenden bevorzugten Ausführungsbeispiel ohne wesentliche bauliche Unterschiede verallgemeinerbar. Wenn die ursprüngliche Datenfolge statt binären Elementen bzw. Bits Symbole aus einem polyvalenten Alphabet mit $N_s$ Symbolen beinhaltet, dazu eine polyvalente Arithmetik im Faltungscodierer und bei der Berechnung der Distanzen angewendet wird, gibt es $N_s^{L-1}$ mögliche Zustände und mehrere Pfade $N_s$ im Zustandsdiagram, die bei einem Übergang zu jedem Zustand führen. Das erfordert einen Vergleich von $N_s$ Distanzen im AV-Block. Bits mit Symbolen werden auch im Viterbi-Decoder VD ersetzt, wobei die Struktur gemäß Figuren 5 - 7 und die Verarbeitungsschritte 1 - 6 des Viterbi-Decoders VD in vorteilhafter Weise unverändert bleiben.

Fig. 1 stellt eine neue Speicherstruktur mit einem zweiteiligen Aufbau dar. Der dargestellte neue Speicher NM besteht aus einem ersten Teil als Speicherteil unter einer Kontrolle durch zusätzliche Kontrollsignale s. Der zweite Teil besteht aus einem Schieberegister.

Diese neue Speicherstruktur führt die zusätzlichen Kontrollsignale $\{s(k), k=0, ..., 2^{L-1}\}$ in einem matrixweiseorganisierten Pfadspeicher PM für die einzelnen Datenelemente $\{m(k,t), k=0, ..., 2^{L-1}; t=0, ..., T-1\}$ ein, welche nach dem Zustandsdiagram und nach dem Vergleichsergebnis alle benötigten Verschiebungen zwischen den einzelnen Pfaden direkt im Speicher ermöglichen. Dadurch wird der entsprechende Pfadbus des Standes der Technik durch einen wesentlich schmaleren Kontrollbus CB als ein Steuerbus zum Übertragen von nur $2^{L-1}$ Bits ersetzt.

In dem ersten Teil des Speichers NM ist eine Verschiebung jedes Bits zwischen den einzelnen Pfaden durch einen von den Kontrollsignalen s(k) gesteuerten Demultiplexer G möglich. Nur die ersten Bits sind in allen Pfaden vorgegeben, wobei in der ersten Hälfte Nullen und in der zweiten Hälfte Einsen vorgegeben werden. Vor allen anderen Bits steht ein Demultiplexer G gemäß den Übergangsregeln nach Gleichung (8). Dabei wird gemäß der bevorzugten Ausführungsform der obere Übergang mit s = 0 und der untere Übergang mit s = 1 gewählt.

Der zweite Teil des Speichers NM besteht nur aus einfachen Schieberegistern und dient dazu, die Verarbeitungsverzögerungen auszugleichen. Die Länge der Schieberegister stimmt vorzugsweise mit der Anzahl der Verzögerungstakte in den AV-Blöcken und bei der Minimumsuche überein.

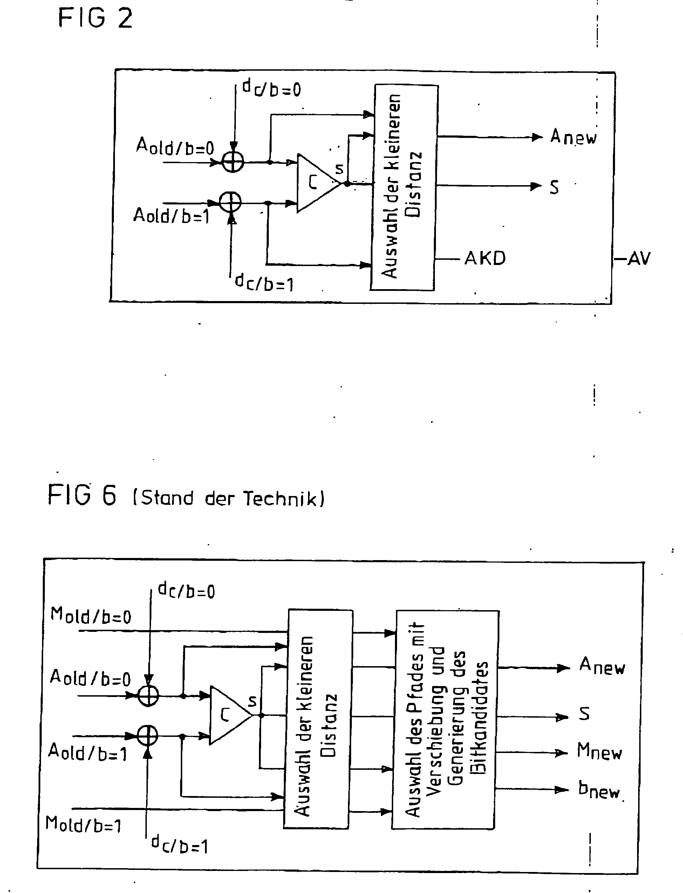

Diese neue Speicherstruktur ermöglicht die Verwendung eines vereinfachten AV-Blocks gemäß Fig. 2. Diesem werden über zwei Eingänge entsprechende Werte $A_{old/b=0}$ bzw. $A_{old/b=1}$ angelegt. Die Eingänge werden zu Eingängen jeweils eines Addierers geführt. Dem ersten Addierer wird ein Distanzwert $d_{c/d=0}$ zur Addition mit dem entsprechenden ersten Eingangswert angelegt. Dem zweiten Addierer wird an den erweiterten Additionseingang ein entsprechender Distanzwert $d_{c/b=1}$ zur Addition angelegt. Die Ausgangswerte der beiden Addierer werden einem Vergleicher C zugeführt. An dessen Ausgang wird ein Kontrollsignal s ausgegeben, welches einerseits einem Ausgang des AV-Blocks AV zugeführt und andererseits einem Block AKD zur Auswahl der kleineren der Distanzen zugeführt wird. Dem Block AKD zur Auswahl der kleineren Distanz werden außerdem die addierten Werte der beiden Addierer zugeführt. In dem Block AKD zur Auswahl der kleineren Distanz findet die Berechnung des neuen Wertes, d. h. die Auswahl der gefundenen minimalen Distanz $A_{new}$ statt. Der AV-Block AV hat daher nur noch zwei Eingänge für Distanzen und zwei Ausgänge, einen für die gefundene minimale Distanz $A_{new}$ und den anderen für das Kontrollsignal s. Dabei gilt s=0, wenn $A_{old/b=0} < A_{old/b=1}$ gilt und sonst s=1.

Diese neue Speicherstruktur NM gemäß Fig. 1 ermöglicht auch eine vereinfachte Ausführung des gesamten Viterbi-Decoders VD, wie dies in Fig. 3 gezeigt ist.

Die Anordnung und Funktionsweise der einzelnen Komponenten entspricht dabei im Wesentlichen dem Stand der Technik gemäß Fig. 8, auf dessen Beschreibung daher verwiesen wird. Unterschiedlich ist insbesondere der Austausch des bidirektionalen Pfadbusses PB gegen einen unidirektionalen Kontrollbus CB von der Berechnungseinrichtung CO mit dem bzw. den AV-Blöcken AV zur Übertragung von $1 \times 2^{p+1}$ Bit zu dem Speicher NM.

Der Speicher NM besteht im Wesentlichen aus dem eigentlichen Pfadspeicher PM und einer Demultiplexeranordnung MX. Der Pfadspeicher dient zum Speichern von $T \times 2^{L-1}$ Bits. Außerdem führt von der Berechnungseinrichtung CO, insbesondere von deren Block zur Minimumsuche und dessen Ausgang eine Adressleitung AL zu dem Speicher NM. Die Adressleitung AL dient zur Übertragung einer Adresse des Zustands mit der minimalen Distanz q mit einem Datenumfang von L-1 Bits, um diese der Demultiplexeranordnung MX zuzuführen. Von dem Speicher NM, bzw. gesteuert über dessen Demultiplexeranordnung MX wird die letztendlich bestimmte Datenbitfolge c(n,k) dem Ausgang des Viterbi-Decoders VD zugeführt.

Der breite Pfadbus PB gemäß dem Stand der Technik ist auf diese Art und Weise durch den schmalen Kontrollbus CB ersetzt. Der große Zwischenspeicher gemäß dem Stand der Technik für die Pfade in der Berechnungseinheit ist vorteilhaft durch einen kleinen Zwischenspeicher ersetzt. Dazu kommen noch L-1 Bits, die als Adresse q des gewählten Pfades zu übertragen sind. Der Demultiplexer bzw. die Demultiplexeranordnung MX wählt für das rekonstruierte Ausgangsbit c(n,k) das letzte Bit in dem Pfad, welcher der minimalen Distanz entspricht. Eine Verzögerung von dem Systemtakt ist im AV-Block vorzugsweise obligatorisch, so dass die alten Distanzen im Distanzspeicher mit den neuberechneten Distanzen rechtzeitig überschrieben werden können. Die Minimumsuche bringt noch eine zusätzliche Verzögerung von D Systemtakten, so dass die Schieberegister am Ende eines jeden Pfades im Pfadspeicher D+1 Systemtakte lang ausgebildet werden, um das entsprechende Ausgangsbit dem gefundenen Minimum korrekt zuzuordnen. Diese Verzögerungen erfordern auch eine geringe Erweiterung des Wertebereiches für Distanzakkumulatoren um ein Bit.

Dieser Viterbi-Decoder VD bietet eine entspannte Abhängigkeit zwischen dem Systemtakt und den Busbreiten, wie dies in Fig. 4 für verschiedene Parallelisierungsgrade p dargestellt ist. Zur Vergleichbarkeit mit Fig. 9 wurden die gleichen Parameter wie in Fig. 9 verwendet.

Der bevorzugte Viterbi-Decoder VD bietet eine wirtschaftlich umsetzbare Busbreite von knapp 900 Bit sogar dann, wenn der Systemtakt gleich der Datenrate ist, was einem Parallelisierungsgrad p = 5 entspricht. Bei dem DVB-Beispiel beträgt der Systemtakt dann 50 MHz. Bei einem Systemtakt von 100 MHz, d. h. bei einem Parallelisierungsgrad p = 4 sinkt die benötigte Busbreite auf 450 Bit, was 10 mal schmaler als die benötigte Busbreite gemäß Standardspeicherstrukturen ist.

Bei dem Viterbi-Decoder VD werden am Eingang Daten bzw. Datenwerte r(n,k) angelegt, welche über üblicherweise eine Funkschnittstelle eines Kommunikationssystems übertragen wurden. Senderseitig wurden die eigentlich zu versendenden Daten, welche empfängerseitig insbesondere durch den Viterbi-Algorithmus zu rekonstruieren sind, mittels einer Fehlerschutzkodierung verarbeitet. Zum Verständnis der zu verarbeitenden Daten wird nachfolgend die Faltungscodierung einer senderseitig zu übertragenden Bitfolge erläutert.

Eine Datenbitfolge {...,b(n), b(n+1)...} soll übertragen werden. Für den Einsatz des Viterbi-Algorithmus auf der Empfängerseite wird diese Datenbitfolge senderseitig auf folgende Weise codiert:

In einem ersten Schritt werden die Daten der Datenbitfolge in einen Schiebepuffer eingeschoben. Der Schiebepuffer der Länge L Bit {B(0), B(1)..., B(L-1)} wird in jedem Schritt nach rechts geschoben {B(m) = B(m-1), m=2,3,..., L-1)} und mit einem neuen Eingangsbit nachgefüllt {B(0) = b(n)}. Die Länge L definiert einen wichtigen Parameter der Codierung, die sogenannte Constraint Length.

In einem zweiten Schritt werden K Ausgangsbits {c(n,k), k=0,1,...,K-1} gemäß dem Pufferzustand am Ausgang berechnet. Die Berechnung ist mit einem Satz von K Generatorpolynomen der Länge L{G(k,m), k=0,1,...,K-1 und m=0,1,...,L-1} mit binären Koeffizienten 0 oder 1 eindeutig bestimmt gemäß

$$c(n,k) \;\; = \;\; \sum_{m=0}^{L-1} G(k,m) \bullet B(m) = \sum_{m=0}^{L-1} G(k,m) \bullet b(n-m)\,, \qquad\qquad (9)$$

wobei die angewendeten Additionen in der Summe als Addition mit Modulo 2 (EXOR) zu verstehen sind. Das Verhältnis zwischen der Anzahl der Nutzbits am Eingang und der Anzahl der zu übertragenden Bits am Ausgang ist als zweiter wichtiger Parameter definiert, nämlich als der Coderate R. In diesem Fall ist R = 1/K.

Drittens kann, um andere Coderaten R zu erzielen, nach der oben beschriebenen Codierung ein sogenanntes Puncturing als eine Nachverarbeitung angewendet werden. In diesem Verfahren werden aus P nacheinander folgenden Sätzen von K Bits nach einer vorgegebenen binären P-Matrix {P(a,b), a=0,1,...,K-1 und b=0,1,...,P-1} bestimmte Bits ausgelassen, welche mit P(a,b) = 0 markiert werden. Mit der Anzahl der "len" in der Matrix P1 lässt sich die Coderate bestimmen zu R = P/P1 zwischen 1/K und 1, wobei maximal alle von den PK Matrixkoeffizienten "1" sind und sich mindestens eine "1" in jeder P-Spalte ergibt.

Fig. 10 verdeutlicht ein Beispiel, bei dem das Codewort eines Faltungscodes unendlich lang sein kann.

Für eine spätere Betrachtung des Viterbi-Algorithmus ist eine Beschreibung der Codierung mittels eines Zustandsdiagrammes sehr hilfreich. Der Zustand des Codierers ist mit den letzten L-1 Bits des Puffers $Z_{B(1),...,B(L-1)}$ eindeutig bestimmt. Im binären Fall gibt es $2^{L-1}$ verschiedene Zustände und aus jedem von ihnen gibt es zwei mögliche Übergänge in einen nächsten Zustand, dies abhängig vom neuen Bit am Eingang b=b(n). Bei jedem Übergang werden K codierte Bits am Ausgang c={c(0),...,c(K-1)} generiert. Die Generatorpolynome sind dabei immer so gewählt, dass in den konkurrierenden zwei Bitsätzen alle K Bits unterschiedlich sind.

Ein Zustandsdiagramm des Faltungscodierers für das beschriebene Beispiel gemäß Fig. 10 ist in Fig. 11 veranschaulicht. Aus dem Zustandsdiagramm folgt, dass nur bestimmte Übergänge möglich sind, zum Beispiel aus den Zuständen {$Z_{00}$, $Z_{01}$} nur zu den Zuständen {$Z_{00}$, $Z_{10}$} und aus {$Z_{10}$, $Z_{11}$} zu den Zuständen {$Z_{01}$, $Z_{11}$}. Diese Betrachtung lässt sich verallgemeinern. Seien alle Zustände mit {$Z_k$, k=0,...,2L-1} beziffert, dann gilt die folgende Übergangsregel

$$\{Z_{2K}, Z_{2K+1}\} \implies \begin{cases} Z_K & \text{mit } b=0, \text{ wobei Code}=c \text{ ist} \\ & \qquad\qquad k=0,\ldots,2^{L-2} \\ Z_2{}^{L-2}{}_{+k} & \text{mit } b=1, \text{ wobei Code}= \bar{c} \text{ ist,} \end{cases}$$

wobei $\bar{c}$ das invertierte Codewort bezeichnet.

Die codierten Daten $\{p(m)\}$ werden anschließend mittels einer Modulation, z. B. QAM (Quadratur Amplituden Modulation) oder PSK (Phase Shift Keying) durch einen Kanal, insbesondere einen Kanal einer Funkschnittstelle eines Kommunikationssystems übertragen. Durch die Übertragung werden sie verzerrt und durch Rauschen und andere Störungssignale überlagert. Mittels des Viterbi-Algorithmus werden die ursprünglichen Daten rekonstruiert.

**Patentansprüche**

1. Decoder (VD) zum Durchführen eines Viterbi-Algorithmus mit

   - einem Eingang zum Eingeben von Empfangsdatenwerten (r(n,k)),
   - einer Berechnungseinrichtung (CO, AV) zum Berechnen benötigter Distanzen $d_0$, $d_1$ für die Empfangsdaten- werte und zum Akkumulieren und Vergleichen der Distanzen nach dem Viterbi-Algorithmus und zum Entscheiden von Datenwerten,
   - einem Pfadspeicher (NM, PM) zum Speichern entschiedener Datenwerte (b)
   - einem Bus (CB) zwischen der Berechnungseinrichtung und dem Pfadspeicher und
   - einem Ausgang zum Ausgeben von zumindest einem Ausgangswert (c(n,k)),

   wobei

   - die Berechnungseinrichtung (CO, AV) ausgelegt ist, Kontrollsignale (s) abhängig von den Entscheidungen zu Pfaden zugeordnet zu generieren,
   - die Berechnungseinrichtung (CO, AV) und/oder der Pfadspeicher (NM, PM) ausgelegt sind, mit den zu Pfaden zugeordneten Kontrollsignale im Pfadspeicher (NM,
   PM) entsprechend Bedingungen des Viterbi-Algorithmus Datenfolgen zu verschieben und
   - der Pfadspeicher (CM, PM) zum Ausgeben von zumindest dem einen Ausgangswert (c(n,k)) ausgelegt ist,

   **dadurch gekennzeichnet, dass**

   - die Berechnungseinrichtung (CO, AV) ausgelegt ist,
   - die benötigten Distanzen für jeden Satz von den Empfangswerten in einem Block auszuwerten und
   - die Distanzen zugeordnet nach dem Viterbi-Algorithmus zu akkumulieren und zu vergleichen, wobei die kleinsten ausgewählt und in einem Distanzspeicher abgelegt werden und
   - die Berechnungsrichtung (CO, AV) und/oder der Pfadspeicher (NM, PM, MX) ausgelegt sind, die Datenfolgen ineinem zweiten Teil des padgpeidiesg durch einfache Schieberegister zu verzögern zum Ausgleichen einer benötigten Zeit für eine Minimumsuche unter den gewählten, akkumulierten Distanzen.

2. Decoder nach dem vorstehenden Anspruch, bei dem die Berechnungseinrichtung (CO, AV) und/oder der Pfadspeicher (NM, PM, MX) ausgelegt sind, den Ausgangswert (c(n,k)) aus dem Pfadspeicher auszugeben, der dem durch Minimumsuche ausgesuchten Pfad mit der minimalen Distanz entspricht.

3. Decoder nach einem vorstehenden Anspruch, bei dem die Berechnungseinrichtung (CO, AV) ausgelegt ist, eine gefundene minimale Distanz von allen akkumulierten Distanzen im nächsten Decoderzyklus abzuziehen.

4. Decoder nach einem vorstehenden Anspruch, bei dem der Pfadspeicher (NM, PM, MX) zeilenweise aufgebaut ist zum Aufnehmen von zeilenweisen Pfaden (m(p,t)) aus den Datenfolgen, die beim Entscheiden zu einem Zustand geführt haben und welche in jedem Decoderzyklus neu verschoben werden sollen.

5. Decoder nach einem vorstehenden Anspruch, bei dem der Pfadspeicher (NM, PM, MX) zwei Teile hat und ausgebildet ist zum Durchführen

- der Verschiebung nach dem Viterbi-Algorithmus im ersten Teil mit einer vorgegebenen Länge (T) und
- der einfachen Verzögerung mittels Schieberegister mit einer weiteren Länge (D) im zweiten Teil.

6. Decoder nach einem vorstehenden Anspruch, bei dem die Berechnungseinrichtung (CD, AV) und/oder der Pfadspeicher (NM, PM, MX) ausgelegt sind, den Anfangswert in jedem Pfad nach einem festen Muster, der nur von einer Pfadnummer abhängig ist, in jedem Decoderzyklus einzuschreiben.

7. Decoder nach einem vorstehenden Anspruch, bei dem die Berechnungseinrichtung (CO, AV) und/oder der Pfadspeicher (NM, PM, MX) ausgelegt sind, mittels der Kontrollsignale (s) am Eingang des Pfadspeichers die Datenverschiebung hinsichtlich der Pfade (m(p,t)) im ersten Teil des Pfadspeichers zu steuern.

8. Decoder nach einem vorstehenden Anspruch, bei dem die Berechnungseinrichtung (CO, AV) und/oder der Pfadspeicher (NM, PM, MX) ausgelegt sind,

- eine einfache Verschiebung in einem zweitem Teil des Pfadspeichers durchzuführen,
- und/oder den ausgewählten Pfad (q) mit der minimalen Distanz als den Ausgangswert zu bestimmen.

9. Viterbi-Decoder (VD) mit einem Decoder nach einem vorstehenden Anspruch und

- einem Distanzspeicher (DM), und
- dem Pfadspeicher, wobei
- ein bidirektionaler Bus (DB) zwischen dem Distanzspeicher (DM) und der Berechnungseinrichtung (CO) angeordnet ist zum Ablesen der akkumulierten Distanz aus dem vorletzten Decoderzyklus und zum Abspeichern von neu berechneten, akkumulierten Distanzen.

10. Viterbi-Decoder (VD) nach Anspruch 9, dessen Systemtakt gleich dem Decoderzyklus ist, wobei

- die Anzahl der Blöcke (AV) für Akkumulation und Vergleich der Berechnungseinrichtung (CO, AV) gleich der Anzahl der Zustände, insbesondere Pfade ist,
- die Busbreite des Busses (DB) zum Distanzspeicher (DM) für ein gleichzeitiges Ablesen und Abspeichern der Distanzen für alle Pfade dimensioniert ist, und
- der Bus (CB) zum Pfadspeicher (NM, PM) alle Kontrollsignale gleichzeitig durchleitet.

11. Viterbi-Decoder (VD) nach Anspruch 9 dessen Systemfrequenz ein Vielfaches X einer Datenrate oder eines Decoderzyklus ist, wobei

- die Anzahl der Blöcke (AV) für Akkumulation und Vergleich in der Berechnungseinrichtung (CO) P/X beträgt, wobei P die Anzahl der Pfade oder Zustände darstellt,
- der Bus (DB) zum Distanzspeicher (DM) zum Ablesen und Abspeichern von P/X Distanzen ausgelegt ist, und
- der Bus (CB) zum Pfadspeicher (PM) zum insbesondere gleichzeitigen Durchleiten von P/X Kontrollsignalen ausgelegt ist.

12. Verfahren zum Durchführen eines Viterbi-Algorithmus, insbesondere mit einem Decoder nach einem vorstehenden Anspruch,
bei dem

- in einen Eingang Empfangsdatenwerte (r(n,k)) eingegeben werden,
- benötigte Distanzen $d_0$, $d_1$ für die Empfangsdatenwerte und zum Akkumulieren und Vergleichen der Distanzen nach dem Viterbi-Algorithmus und zum Entscheiden von Datenwerten in einer Berechnungseinrichtung (CO, AV) berechnet werden,
- in einem Pfadspeicher (PM) entschiedene Datenwerte (b) gespeichert werden,
- über einen Bus (CB) zwischen der Berechnungseinrichtung und dem Pfadspeicher Datenwerte übertragen werden und
- über einen Ausgang zumindest ein Ausgangswert (c.(n,k)) ausgegeben wird,
- Kontrollsignale (s) abhängig von den Entscheidungen zu Pfaden zugeordnet generiert werden,
- die zu Pfaden zugeordneten Kontrollsignale im Pfadspeicher (PM) entsprechend Bedingungen des Viterbi-Algorithmus Datenfolgen verschieben und
- der Ausgangswert (c(n,k)) aus dem Pfadspeicher (NM, PM, MX) ausgegeben wird,

**dadurch gekennzeichnet, dass**

- die benötigten Distanzen, insbesondere alle benötigten Distanzen für jeden Satz von den Empfangswerten in einem Block ausgewertet werden
- die Distanzen zugeordnet nach dem Viterbi-Algorithmus akkumuliert und verglichen werden, wobei die insbesondere kleinsten Distanzen ausgewählt und in einem Distanzspeicher abgelegt werden, und
- die Datenfolgen in einem zweiten Teil des Pfadspeichers durch einfache Schieberegister verzögert werden zum Ausgleichen einer benötigten Zeit für eine Minimumsuche unter den gewählten, akkumulierten Distanzen.

13. Verfahren nach Anspruch 12, bei dem der zumindest eine Ausgangswert (c(n,k)) aus dem Pfadspeicher ausgegeben wird, der dem durch Minimumsuche ausgesuchten Pfad mit der minimalen Distanz entspricht.

14. Verfahren nach einem der Ansprüche 12 bei dem eine gefundene minimale Distanz von allen akkumulierten Distanzen im nächsten Decoderzyklus abgezogen wird.

15. Verfahren nach einem der Ansprüche 12 - 14, bei dem im Pfadspeicher (NM, PM, MX) zeilenweise Pfade (m(p,t)) aus den Datenfolgen aufgenommen werden, die beim Entscheiden zu einem Zustand geführt haben und welche in jedem Decoderzyklus neu verschoben werden sollen.

16. Verfahren nach einem der Ansprüche 12 - 15, bei dem der Pfadspeicher (NM, PM, MX) zwei Teile hat und

- die Verschiebung nach dem Viterbi-Algorithmus im ersten Teil mit einer vorgegebenen Länge (T) und
- eine insbesondere einfache Verzögerung mittels Schieberegistern mit einer weiteren Länge (D) im zweiten Teil durchgeführt wird.

17. Verfahren nach einem der Ansprüche 12 - 16, bei dem der Anfangswert in jedem Pfad nach einem festen Muster, der nur von einer Pfadnummer abhängig ist, in jedem Decoderzyklus eingeschrieben wird.

18. Verfahren nach einem der Ansprüche 12 - 17, bei dem mittels der Kontrollsignale (s) am Eingang des Pfadspeichers die Datenverschiebung hinsichtlich der Pfade (m(p,t)) im ersten Teil des Pfadspeichers gesteuert wird.

19. Verfahren nach der Ansprüche 12 - 18, bei dem

- eine einfache Verschiebung in einem zweitem Teil des Pfadspeichers durchgeführt wird,
- und/oder der ausgewählte Pfad (q) mit der minimalen Distanz als der Ausgangswert bestimmt wird.

20. Verfahren nach einem der Ansprüche 12 - 19, unter Verwendung eines Decoders nach einem der Ansprüche 10 bis 11.

**Claims**

1. A decoder (VD) for carrying out a Viterbi algorithm, comprising

- an input for inputting reception data values (r(n,k)),
- a calculation device (CO, AV) for calculating required distances $d_0$, $d_1$ for the reception data values and for accumulating and comparing the distances according to the Viterbi algorithm and for deciding on data values,
- a path memory (NM, PM) for the storage of decided data values (b),
- a bus (CB) between the calculation device (CO, AV) and the path memory and
- an output for delivering at least one initial value (c(n,k)),

wherein

- the calculation device (CO, AV) is designed to generate control signals (s) depending on the decisions so as to be associated to paths,

**EP 1 626 507 B1**

- the calculation device (CO, AV) and/or the path memory (NM, PM) are designed to shift data sequences in the path memory (NM, PM), with the control signals associated to paths, according to conditions of the Viterbi algorithm and
- the path memory (CM, PM) is designed to deliver the at least one initial value (c(n,k)),

**characterized in that**

- the calculation device (CO, AV) is designed to
- evaluate the required distances for each set of the reception data values in a block and
- to accumulate and compare the distances associated according to the Viterbi algorithm, the smallest distances being selected and stored in a distance memory and
- the calculation device (CO, AV) and/or the path memory (NM, PM, MX) are designed to delay the data sequences in a second part of the path memory by ordinary shift registers in order to compensate for a time required for a minimum search among the selected, accumulated distances.

2. The decoder according to the preceding claim, wherein the calculation device (CO, AV) and/or the path memory (NM, PM, MX) are designed to output the initial value (c(n,k)) from the path memory which corresponds to the path exhibiting the minimum distance and selected by the minimum search.

3. The decoder according to any preceding claim, wherein the calculation device (CO, AV) is designed to subtract a determined minimum distance from all accumulated distances in the next decoder cycle.

4. The decoder according to any preceding claim, wherein the path memory (NM, PM, MX) has a line-by-line design for receiving line-by-line paths (m(p,t)) from the data sequences which have led to a state during the decision process and are to be shifted again in each decoder cycle.

5. The decoder according to any preceding claim, wherein the path memory (NM, PM, MX) has two parts and is configured for carrying out

- the shifting process according to the Viterbi algorithm in the first part having a given length (T) and
- the single delay by means of shift registers having another length (D) in the second part.

6. The decoder according to any preceding claim, wherein the calculation device (CO, AV) and/or the path memory (NM, PM, MX) are designed to write the initial value in each path according to a fixed pattern, which only depends on a path number, in each decoder cycle.

7. The decoder according to any preceding claim, wherein the calculation device (CO, AV) and/or the path memory (NM, PM, MX) are designed to control the data movement with respect to the paths (m(p,t)) in the first part of the path memory by means of the control signals (s) at the input of the path memory.

8. The decoder according to any preceding claim, wherein the calculation device (CO, AV) and/or the path memory (NM, PM, MX) are designed to

- carry out a single shifting process in a second part of the path memory,
- and/or to determine the selected path (q) exhibiting the minimum distance as the initial value (c(n,k)).

9. A Viterbi decoder (VD) comprising a decoder according to any preceding claim and

- a distance memory (DM), and
- the path memory, wherein
- a bidirectional bus (DB) is arranged between the distance memory (DM) and the calculation device (CO) for reading the accumulated distance from the last but one decoder cycle and for storing recalculated accumulated distances.

10. The Viterbi decoder (VD) according to claim 9, the system clock of which is equal to the decoder cycle, wherein

- the number of the blocks (AV) for accumulation and comparison of the calculation device (CO, AV) is equal to the number of states, in particular paths,

13

- the bus width of the bus (DB) to the distance memory (DM) is dimensioned for simultaneously reading and storing the distances for all paths, and
- the bus (CB) to the path memory (NM, PM) passes all control signals at the same time.

11. The Viterbi decoder (VD) according to claim 9, whose system frequency is a multiple X of a data rate or of a decoder cycle, wherein

- the number of blocks (AV) for accumulation and comparison in the calculation device (CO) amounts to P/X, with P representing the number of paths or states,
- the bus (DB) to the distance memory (DM) is designed to read and store P/X distances, and
- the bus (CB) to the path memory (PM) is designed for the in particular simultaneous passage of P/X control signals.

12. A method for carrying out a Viterbi algorithm, in particular with a decoder according to a preceding claim, wherein

- reception data values (r(n,k)) are supplied to an input,
- required distances $d_0$, $d_1$ for the reception data values and for accumulating and comparing the distances according to the Viterbi algorithm and for deciding on data values are calculated in a calculation device (CO, AV),
- decided data values (b) are stored in a path memory (PM),
- data values are transferred via a bus (CB) between the calculation device and the path memory and
- at least one initial value (c(n,k)) is delivered via an output,
- control signals (s) are generated depending on the decisions so as to be associated to paths,
- data sequences are shifted by the control signals, associated to paths, in the path memory (PM) according to conditions of the Viterbi algorithm and
- the initial value (c(n,k)) is output from the path memory (NM, PM, MX),

**characterized in that**

- the required distances are evaluated, in particular all required distances for each set of the reception data values in a block,
- the distances allocated according to the Viterbi algorithm are accumulated and compared, in particular the smallest distances being selected and stored in a distance memory, and
- the data sequences are delayed in a second part of the path memory by ordinary shift registers in order to compensate for a time required for a minimum search among the selected, accumulated distances.

13. The method according to claim 12, wherein the at least one initial value (c(n,k)) is output from the path memory which corresponds to the path exhibiting the minimum distance and selected by minimum search.

14. The method according to any one of claims 12 to 13, wherein a determined minimum distance is subtracted from all accumulated distances in the next decoder cycle.

15. The method according to any one of claims 12 to 14, wherein the path memory (NM, PM, MX) receives paths (m(p,t)) from the data sequences in a line-by-line manner, which have led to a state during the decision and are to be shifted again in each decoder cycle.

16. The method according to any one of claims 12 to 15, wherein the path memory (NM, PM, MX) comprises two parts and

- the shifting process is performed according to the Viterbi algorithm in the first part having a given length (T) and
- an in particular simple delay is performed by means of shift registers having another length (D) in the second part.

17. The method according to any one of claims 12 to 16, wherein the initial value is written in each path according to a fixed pattern, which only depends on a path number, in each decoder cycle.

18. The method according to any one of claims 12 to 17, wherein the data movement with respect to the paths (m(p, t)) in the first part of the path memory is controlled by means of the control signals (s) at the input of the path memory.

19. The method according to any one of claims 12 to 18, wherein

- a single shifting process is performed in a second part of the path memory,
- and/or the selected path (q) exhibiting the minimum distance is determined as the initial value.

20. The method according to any one of claims 12 to 19, using a decoder according to any one of claims 10 to 11.

**Revendications**

1. Décodeur (VD) destiné à exécuter un algorithme de Viterbi, comportant

- une entrée servant à entrer des valeurs de données de réception (r(n,k)),
- un dispositif de calcul (CO, AV) servant à calculer des distances requises $d_0$, $d_1$ pour les valeurs de données de réception et à cumuler et comparer les distances selon l'algorithme de Viterbi et à déterminer des valeurs de données,
- une mémoire de chemins (NM, PM) servant à mémoriser des valeurs de données sélectionnées (b),
- un bus (CB) entre le dispositif de calcul et la mémoire de chemins et
- une sortie servant à sortir au moins une valeur de sortie (c(n,k)),

sachant que

- le dispositif de calcul (CO, AV) est conçu pour générer des signaux de contrôle (s) en fonction des sélections en les attribuant à des chemins,
- le dispositif de calcul (CO, AV) et/ou la mémoire de chemins (NM, PM) sont conçus pour décaler des suites de données avec les signaux de contrôle attribués à des chemins dans la mémoire de chemins (NM, PM) conformément à des conditions de l'algorithme de Viterbi et
- la mémoire de chemins (CM, PM) est conçue pour sortir au moins ladite valeur de sortie (c(n,k)),

**caractérisé en ce que**
le dispositif de calcul (CO, AV) est conçu pour

- évaluer les distances requises pour chaque jeu des valeurs de réception dans un bloc et
- cumuler et comparer les distances en les attribuant selon l'algorithme de Viterbi, les plus petites étant sélectionnées et mémorisées dans une mémoire de distances, et

le dispositif de calcul (CO, AV) et/ou la mémoire de chemins (NM, PM, MX) sont conçus pour retarder les suites de données dans une deuxième partie de la mémoire de chemins par des registres simples à décalage pour compenser un temps requis pour une recherche de minimum parmi les distances cumulées choisies.

2. Décodeur selon la revendication précédente, où le dispositif de calcul (CO, AV) et/ou la mémoire de chemins (NM, PM, MX) sont conçus pour sortir la valeur de sortie (c(n,k)) de la mémoire de chemins qui correspond au chemin sélectionné par recherche de minimum et présentant la distance minimale.

3. Décodeur selon une revendication précédente, où le dispositif de calcul (CO, AV) est conçu pour soustraire une distance minimale trouvée de toutes les distances cumulées dans le prochain cycle du décodeur.

4. Décodeur selon une revendication précédente, où la mémoire de chemins (NM, PM, MX) est configurée ligne par ligne pour accueillir des chemins ligne par ligne (m(p, t) à partir des suites de données qui ont conduit à un état lors de la sélection et qu'il convient de redécaler à chaque cycle du décodeur.

5. Décodeur selon une revendication précédente, où la mémoire de chemins (NM, PM, MX) comporte deux parties et est constituée pour effectuer

- le décalage selon l'algorithme de Viterbi dans la première partie avec une longueur prédéterminée (T) et
- le retard simple au moyen de registres à décalage avec une longueur supplémentaire (D) dans la deuxième partie.

6. Décodeur selon une revendication précédente, où le dispositif de calcul (CD, AV) et/ou la mémoire de chemins (NM, PM, MX) sont conçus pour inscrire à chaque cycle du décodeur la valeur de début dans chaque chemin selon un modèle fixe qui ne dépend que d'un numéro de chemin.

7. Décodeur selon une revendication précédente, où le dispositif de calcul (CO, AV) et/ou la mémoire de chemins (NM, PM, MX) sont conçus pour commander au moyen des signaux de contrôle (s) à l'entrée de la mémoire de chemins le décalage de données eu égard aux chemins (m(p,t)) se trouvant dans la première partie de la mémoire de chemins.

8. Décodeur selon une revendication précédente, où le dispositif de calcul (CO, AV) et/ou la mémoire de chemins (NM, PM, MX) sont conçus pour

   - effectuer un décalage simple dans une deuxième partie de la mémoire de chemins,
   - et/ou déterminer le chemin sélectionné (q) ayant la distance minimale comme la valeur de sortie.

9. Décodeur de Viterbi (VD) comportant un décodeur selon une revendication précédente et

   - une mémoire de distances (DM), et
   - la mémoire de chemins, sachant que
   - un bus bidirectionnel (DB) est disposé entre la mémoire de distances (DM) et le dispositif de calcul (CO) pour relever la distance cumulée à partir de l'avant-dernier cycle du décodeur et pour mémoriser des distances cumulées recalculées.

10. Décodeur de Viterbi (VD) selon la revendication 9, dont la cadence de système est égale au cycle du décodeur, sachant que

    - le nombre de blocs (AV) pour le cumul et la comparaison dans le dispositif de calcul (CO, AV) est égal au nombre d'états, en particulier de chemins,
    - la largeur du bus (DB) par rapport à la mémoire de distances (DM) est dimensionné pour relever et mémoriser simultanément les distances pour tous les chemins, et
    - le bus (CB) reliant la mémoire de chemins (NM, PM) achemine simultanément tous les signaux de contrôle.

11. Décodeur de Viterbi (VD) selon la revendication 9, dont la fréquence de système est x fois supérieure à un débit de données ou à un cycle de décodeur, sachant que

    - le nombre de blocs (AV) pour le cumul et la comparaison dans le dispositif de calcul (CO) est de P/X, P représentant le nombre de chemins ou d'états,
    - le bus (DB) reliant la mémoire de distances (DM) est conçu pour relever et mémoriser P/X distances, et
    - le bus (CB) reliant la mémoire de chemins (PM) est conçu pour acheminer en particulier simultanément P/X signaux de contrôle.

12. Procédé destiné à exécuter un algorithme de Viterbi, notamment avec un décodeur selon une revendication précédente,
    où

    - des valeurs de données de réception (r(n,k)) sont entrées dans une entrée,
    - des distances requises $d_0$, $d_1$ sont calculées dans un dispositif de calcul (CO, AV) pour les valeurs de données de réception et pour cumuler et comparer les distances selon l'algorithme de Viterbi et pour déterminer des valeurs de données,
    - des valeurs de données sélectionnées (b) sont mémorisées dans une mémoire de chemins (PM),
    - des valeurs de données sont transmises via un bus (CB) entre le dispositif de calcul et la mémoire de chemins et
    - au moins une valeur de sortie (c(n,k)) est sortie via une sortie,
    - des signaux de contrôle (s) sont générés en fonction des sélections en étant attribués à des chemins,
    - les signaux de contrôle attribués à des chemins dans la mémoire de chemins (PM) décalent des suites de données conformément à des conditions de l'algorithme de Viterbi et
    - la valeur de sortie (c(n,k)) est sortie de la mémoire de chemins (NM, PM, MX),

    **caractérisé en ce que**

    - les distances requises, en particulier toutes les distances requises pour chaque jeu des valeurs de réception sont évaluées dans un bloc,
- les distances sont cumulées et comparées en étant attribuées selon l'algorithme de Viterbi, les plus petites notamment étant sélectionnées et mémorisées dans une mémoire de distances, et
- les suites de données sont retardées dans une deuxième partie de la mémoire de chemins par des registres simples à décalage pour compenser un temps requis pour une recherche de minimum parmi les distances cumulées choisies.

13. Procédé selon la revendication 12, où l'au moins une valeur de sortie (c(n,k)) est sortie de la mémoire de chemins qui correspond au chemin sélectionné par recherche de minimum et présentant la distance minimale.

14. Procédé selon la revendication 12, où une distance minimale trouvée est soustraite de toutes les distances cumulées dans le prochain cycle du décodeur.

15. Procédé selon l'une des revendications 12 à 14, où des chemins ligne par ligne (m(p,t)) dans la mémoire de chemins (NM, PM, MX) sont accueillis à partir des suites de données qui ont conduit à un état lors de la sélection et qu'il convient de redécaler à chaque cycle du décodeur.

16. Procédé selon l'une des revendications 12 à 15, où la mémoire de chemins (NM, PM, MX) comporte deux parties et

- le décalage est effectué selon l'algorithme de Viterbi avec une longueur prédéterminée (T) dans la première partie et
- un retard, en particulier simple, est effectué au moyen de registres à décalage avec une longueur supplémentaire (D) dans la deuxième partie.

17. Procédé selon l'une des revendications 12 à 16, où la valeur de début dans chaque chemin est inscrite à chaque cycle du décodeur selon un modèle fixe qui ne dépend que d'un numéro de chemin.

18. Procédé selon l'une des revendications 12 à 17, où le décalage de données est commandé au moyen des signaux de contrôle (s) à l'entrée de la mémoire de chemins eu égard aux chemins (m(p,t)) se trouvant dans la première partie de la mémoire de chemins.

19. Procédé selon l'une des revendications 12 à 18, où

- un décalage simple est effectué dans une deuxième partie de la mémoire de chemins,
- et/ou le chemin sélectionné (q) ayant la distance minimale est déterminé comme la valeur de sortie.

20. Procédé selon l'une des revendications 12 à 19, utilisant un décodeur selon l'une des revendications 10 à 11.

FIG 1

FIG 2

$d_{c/b=0}$

$A_{old/b=0}$

$A_{old/b=1}$

$d_{c/b=1}$

C

s

Auswahl der kleineren Distanz

A_new

S

AKD

—AV

FIG 6 (Stand der Technik)

$d_{c/b=0}$

$M_{old/b=0}$

$A_{old/b=0}$

$A_{old/b=1}$

$M_{old/b=1}$

$d_{c/b=1}$

C

s

Auswahl der kleineren Distanz

Auswahl des Pfades mit Verschiebung und Generierung des Bitkandidates

A_new

S

M_new

b_new

# FIG 3

$t(n,k)$ $\xrightarrow{\text{Empfängerbus}}$ $K \times N$ Bits → GD

Gesamtdistanzen $2^K \times (N + \text{ld}(K))$ Bits

VD

CO

DB

DM Distanzspeicher $(N + \text{ld}(K) + 1) \times 2^{L-1}$ Bits

Distanzbus: $2 \times (N + \text{ld}(K) + 2) \times 2^{P+1}$ Bits

DB

Zwischen speicher

AV
AV

MX  PM  NM

Demultiplexer

Pfadspeicher $T \times 2^{L-1}$ Bits

CB

Kontrollbus $1 \times 2^{P+1}$ Bits

Zwischen speicher

Minimum- suche und Ausgang

Adresse des Zustandes mit der minimalen Distanz „q" $L-1$ Bits

AL

$c(n,k)$ Datenbitfolge am Ausgang

EP 1 626 507 B1

EP 1 626 507 B1

FIG 4

FIG 9 (Stand der Technik)

21

## FIG 5 (Stand der Technik)

## FIG 7 (Stand der Technik)

# FIG 8 (Stand der Technik)

VD

$r(n,k) \dfrac{\text{Empfängerbus}}{K \times N \text{ Bits}}$ → GD

Gesamtdistanzen
$2^K \times (N+ld(K)) \text{ Bits}$

CO

DM
Distanzspeicher
$(N+ld(K)+1) \times 2^{L-1}$
Bits

Distanzbus: $2 \times$
$(N+ld(K)+1) \times 2^{P+1} \text{ Bits}$

DB

DB

Zwischen speicher

PM
Pfadspeicher
$T \times 2^{L-1} \text{ Bits}$

PB

Pfadbus: $2 \times$
$T \times 2^{P+1} \text{ Bits}$

PB

AV

Zwischen speicher

Minimumsuche
und
Ausgang

$c(n,k)$
Datenbitfolge
Am Ausgang

EP 1 626 507 B1

FIG 10 (Stand der Technik)

$$L=3 \quad K=2$$

$$G=\begin{Bmatrix} 1,1,1 \\ 1,0,1 \end{Bmatrix}$$

$$R=\frac{2}{3} \quad \Rightarrow \quad P=2; P1=3 \quad P=\begin{Bmatrix} 1,1 \\ 1,0 \end{Bmatrix}$$

Faltungscoder    Puncturing

Beispiel für Codierung einer Datenbitfolge:

```
b:...........10110010001110.........
    (...........10110010001110..........
B:{...........01011001000111...........
    (...........00101100100011..........
c:{...........11000111101010..........
    (...........10011110101101..........
p:.............1110000111111101101100.......
```

FIG 11 (Stand der Technik)

Übergang

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0769853 A1
- US 5448583 A
- EP 543554 A


**In der Beschreibung aufgeführte Nicht-Patentliteratur**

- **G. David Forney, JR.** The Viterbi Algorithm. *Proc. IEEE,* 03. Marz 1973, vol. 61, 268-278
- **H. Burckhardt ; L. C. Barbosa.** Contributions to the Application of the Viterbi Algorithm. *IEEE Trans. on IT,* September 1985, vol. 31 (5), 626-634
- **Mario Steinert ; Stefano Marsili.** Power consumption optimization for low latency Viterbi decoder. *Proceedings des 2004 International Symposium on Circuits and Systems,* 23. Mai 2004, 377-380
- **Peter Bonek ; Andre Ivanov ; Samir Kallel.** A variable rate constraint length K=5 Viterbi decoder for 12 mb/s. *Proceedings der Canadian Conference on electrical and computer Engineering,* 14. September 1993, 582-585
- **Robert Cypher ; C. Bernard Shung.** Generalized trace-back techniques for survivor memory management in the viterbi algorithm. *Journal of VLSI signal processing systems for signal, image and video technology,* Januar 1993, vol. 5 (1), 85-94
- **Samirkumar Ranpara ; Dong Sam Ha.** A low-power Viterbi decoder design for wirelesscommunication applications. *Proceedings der ASIC/SOC Conference 1999,* 15. September 1999, 377-381